(19) Europäisches Patentamt
European Patent Office
Office européen des brevets

(11) **EP 3 494 640 B1**

(12) **EUROPEAN PATENT SPECIFICATION**

(45) Date of publication and mention of the grant of the patent:
**02.09.2020 Bulletin 2020/36**

(51) Int Cl.:
*H03M 3/00* *(2006.01)*   *H03C 3/40* *(2006.01)*
*H03D 3/00* *(2006.01)*

(21) Application number: **16750143.6**

(22) Date of filing: **02.08.2016**

(86) International application number:
**PCT/EP2016/068402**

(87) International publication number:
**WO 2018/024316 (08.02.2018 Gazette 2018/06)**

(54) **DELTA-SIGMA CONVERTER WITH PM/FM NON-LINEAR LOOP**

DELTA-SIGMA-WANDLER MIT NICHTLINEARER PM/FM-SCHLEIFE

CONVERTISSEUR DELTA-SIGMA AVEC BOUCLE NON LINÉAIRE PM/FM

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**12.06.2019 Bulletin 2019/24**

(73) Proprietor: **Fundacio Centre Tecnologic de Telecomunicacions de Catalunya**
**08860 Castelldefels (Barcelona) (ES)**

(72) Inventors:
- **RUBIO FERNÁNDEZ, José**
  **08860 Castelldefels (Barcelona) (ES)**
- **PÉREZ NEIRA, Ana Isabel**
  **08860 Castelldefels (Barcelona) (ES)**
- **LAGUNAS HERNÁNDEZ, Miguel Angel**
  **08860 Castelldefels (Barcelona) (ES)**

(74) Representative: **Mohammadian, Dario**
**KUKATI**
**Apartado de Correos 34031**
**08080 Barcelona (ES)**

(56) References cited:
**WO-A1-01/11786**

- **YASUDA A ET AL: "Bandpass [Delta]-Sigma modulator with frequency converters in feedback loop", ELECTRONICS LETTERS, IEE STEVENAGE, GB, vol. 34, no. 24, 26 November 1998 (1998-11-26), pages 2293-2295, XP006010673, ISSN: 0013-5194, DOI: 10.1049/EL:19981647**

**Description**

**TECHNICAL FIELD**

The present invention relates generally to the field of analog to digital converters, more particularly, deals with an improved delta sigma-converter including a PM/FM non-linear loop which allows to represent a signal with finite dynamic range by a discrete signal using a finite set of amplitude levels, obtaining higher gains than traditional Delta Sigma converter, preserving or improving the oversampling and noise shaping gains of these converters.

**STATE OF THE ART**

One of the key problems in representing an analog signal by a discrete signal is the socalled quantization error. Quantization error is motivated by the discretization of the continuous amplitude values in a given period of time by a constant amplitude selected from a given set of values named alphabet. Currently, the basic tools to combat the effects of the quantization error when trying to recover the original analog signal are basically two. The first is oversampling which entails to reduce as much as possible the period of time that the constant amplitude represents the original analog signal. The second is the so-called noiseshaping which basically consists on shaping the spectral content of the quantization error such that it reduces the overlap with the spectral content of the original signal.

When trying to reduce as much as possible the length of the alphabet to just two or three levels, the major contribution has been the delta-sigma converter (known as $\Delta\Sigma$ or DS converter), sometimes described as 1-bit analog to digital converter (or 1-bit $\Delta\Sigma$). Current commercial systems with $\Delta\Sigma$ technology, fully implanted in the audio industry, achieve that with a single bit, i.e. two amplitude levels, produce the same quality as a traditional converter of 16 bits (65536 levels). The quality is in terms of power of the original signal versus power of the quantization error or noise (the quotient is denoted as the signal to noise ratio of the converter SNRQ). The impact of $\Delta\Sigma$ technology is tremendous and the number of technical papers on the topic is very large. A good paper, widely referenced, with the principles of DS as well as improvements over the original idea is P.M.Aziz, H.V. Sorensen, J.Van der Spiegel. "An overview of Sigma-Delta Converters: How 1- bit ADC achieves more than 16-bit resolution". IEEE Signal Processing Magazine, Vol. 13, Issue 1, pp. 61-84, September 1996.

Non-linear processing, in general frequency (FM) or phase modulators (PM), has been reported implemented as a pre-processing cascade before the $\Delta\Sigma$ converter. Examples of these converters using FM modulator or Hadamard modulators, can be found for example on M Hovin, A. Olsen, T. Sverre Lande, C. Toumazou. " Delta-Sigma Modulators using Frequency-Modulated Intermediate Values". IEEE Journal of Solid State Circuits. Vol. 32, No. 1, pp. 13-22, January 1997. None of the existing modification alters the basic loop of the $\Delta\Sigma$ converter.

The basic loop of a DS ($\Delta\Sigma$) converter is composed of an integrator followed by a quantizer (for example a two-level quantizer with amplitudes +/- A or "mid-tread" or a three levels quantizer with amplitudes 0,+A,-A named "mid-raiser"). The output signal is feedback to the input, such that the difference ($\Delta$- delta) of the original signal minus the feedback output forms the input to the integrator ($\Sigma$- sigma). This basic loop implements both oversampling and noise shaping principles in order to produce a discrete version of the original signal. The original signal is recovered by lowpass filtering the discrete version at the output of the $\Delta\Sigma$ converter.

In order to further increase the quality of the basic $\Delta\Sigma$ converter, additional loops can be imbricated in the original scheme. This is referred to as high order $\Delta\Sigma$ converters, where the order reflects the number of feedback loops used or number of "delta" blocks forming the converter. The $\Delta\Sigma$ described in the previous paragraph is denoted as first order $\Delta\Sigma$ or DS converter. High order $\Delta\Sigma$ modulators can also be achieved by cascading first order modulators. Other techniques like time interleaved $\Delta\Sigma$ converters increase also the quality of the first order $\Delta\Sigma$ by setting several order one $\Delta\Sigma$ converters in parallel.

In general, all the architectures reported with order greater than one produce better quality at the expense of sensitivity to implementation imperfections due to the presence of multiples loops in the corresponding architecture. Furthermore, the in-phase/quadrature components structure of a band pass signal has not been fully used to improve the performance of $\Delta\Sigma$ converters.

The basic tools/arguments that provide the goodness of $\Delta\Sigma$ or DS (delta/sigma) converters still remain as the two originals, i.e. oversampling and noise shaping. In all cases found in the literature, the desired signal is not protected against channel noise.

The embodiments of the invention proposed in the present specification below will overcome at least some of the mentioned drawbacks.

**SUMMARY OF INVENTION**

The present invention is defined in the attached independent claims. Specific optional embodiments of the invention are defined in the attached dependent claims. The problems found in prior art techniques are generally solved or circumvented, and technical advantages are generally achieved, by the disclosed embodiments which provide a device, system and method for improved delta-sigma conversion.

The present invention is able to represent a signal (a low pass analog signal) with finite dynamic range by a discrete signal using a finite set of amplitude levels, in an improved way. Gains from one bit to five bits, i.e. 15-30 dB of Signal to Noise Ratio ($SNR_Q$) over the gains obtained from a first order, let us say, traditional Delta Sigma converter ($\Delta\Sigma$ or DS) are obtained, yet preserving the oversampling and noise shaping gains of these converters. Aside from achieving a technique of low complexity for analog to digital conversion, the invention provides protection against channel noise, at the same time that it provides significant reduction on the impact of the quantization noise.

More precisely, an object of the invention is to introduce a non-linear instantaneous transformation/modulation in the basic loop of the DS converter. This transformation consists of a Phase Modulator (PM) or a Frequency Modulator (FM), that depending on the modulation index, $\Phi_d$ (radians) for PM and $f_d$ (Hz). for FM, controls the existing tradeoff between bandwidth of the resulting discrete signal and the $SNR_Q$ gain of the converter. The proposed converter will be called from now on: Non-linear delta sigma modulation, NDM. Furthermore, NDMPM will denote a phase modulation transformation and NDMFM a frequency modulation transformation.

The data input for the converter could be for example an analog low-pass band limited signal of bandwidth B Hz, or its sample and hold version, at sampling rate with frequency $B_T$ samples per second, being the quotient $B_T/2B$ the so-called oversampling ratio.

The main feature of the proposed invention is that the signal after the delta operation, followed by the sigma operation, and usually before entering into the quantizer (also called quantization unit) is modulated in phase or in frequency. This processing is the responsible for the extra gain on quantization noise and channel noise protection.

The PM or FM signal may be generated as in-phase and quadrature components of a selected carrier frequency fc (fc>BT/2). The in-phase component may be formed by the PM/FM modulation of a cosine and the quadrature component may be formed by the same modulation PM/FM of a sine. This allows the use of two quantizers in parallel, which provides in essence a gain of 6 dB over the traditional DS converter with minimum complexity. Furthermore, for 1-bit converter the overall in-phase and quadrature modulation plus the two parallel quantizers can be implemented by a processor that depending on the range of the analog signal after the sigma operation maps on different and discrete phases of the carrier frequency. For example, using 1 bit mid-riser quantizer, depending on the dynamic range of the input signal, the processor maps into four phases or frequencies. Using three levels mid-tread the input signal is mapped into eight different phases or frequencies. This allows direct and very low complexity implementation of the modulation/conversion stage of the invention. The corresponding in-phase and quadrature components, formed as the quantized versions of the cosine and sine, after low pass filtering at $B_T/2$, are applied to an i-q modulator to produce a PM/FM band-pass signal. Note that the low pass filtering is equivalent to the so-called pulse-shaping in digital communications. The proposed converter preserves the rule of 6 dB per bit increase for a number of bits above 2 using mid-raiser or mid-tread quantizers.

In a first aspect, it is proposed a device for analog-to-digital converting of an analog input signal into a digital output signal. The device comprises a Delta-Sigma, DS, converter, the DS converter comprising a substraction unit (delta unit), an integration unit (sigma unit, which performs an integration/sigma operation), a quantization unit and a delay unit, the device being characterized by further comprising:

-    A phase modulator, PM, (for phase modulation before obtaining the output signal) in the (main) feed-forward branch (feed-forward branch of the basic loop) of the DS converter and a phase demodulator in the (main) feedback brach (feedback branch of the basic loop) of the DS converter (for phase demodulation before feeding the delta/substraction unit)

     or

-    A frequency modulator, FM, (for frequency modulation before obtaining the output signal) in the (main) feed-forward branch (feed-forward branch of the basic loop) of the DS converter and a frequency demodulator in the (main) feedback brach (feedback branch of the basic loop) of the DS converter (for frequency demodulation before feeding the delta/substraction unit).

The phase modulator or the frequency modulator may be connected in series with the quantization unit and the output of the phase modulator or the frequency modulator may be connected to the input of the quantization unit (the output of the quantization unit will be the digital output signal of the converter).

In an embodiment, the phase modulator or the frequency modulator is connected in series with the substraction unit, the integration unit and the quantization unit of the DS converter in the following way: the input of the phase modulator or the frequency modulator is connected to the output of the integration unit, the output (or outputs) of the phase modulator or the frequency modulator is connected to the input of the quantization unit and the output of the substraction unit is connected to the input of the integration unit (the substraction unit substract to the input signal, the output of the main feedback branch).

In an embodiment, the input of the phase demodulator or the frequency demodulator is connected to the output of the quantization unit.

In an embodiment, the phase demodulator or the frequency demodulator is connected in series with the delay unit, where the output of the phase demodulator or the frequency demodulator is connected to the input of the delay unit and the output of the delay unit is an input of the substraction unit.

The device may further comprise a low pass filter. The input of the the low pass filter may be connected to the output of the delay unit and the output of the low pass filter may be an input of the substraction unit

The device may further comprise a sample and hold unit which processes the analog input signal at a selected sampling frequency; the resulting sampled signal will be an input of the substraction unit of the DS converter (the substraction unit substracts to the sampled input signal, the output of the main feedback branch).

The analog input signal may be an audio signal, a video signal and audio-video signal or any type of electronic signal.

The output of the phase modulator or the frequency modulator usually includes an in-phase component and a quadrature component.

In a second aspect, it is proposed a system which comprises the previously described device, that is, a signal processing device for analog-to-digital converting of an analog input signal into a digital output signal. The device comprises a Delta-Sigma, DS, converter, the DS converter comprising a substraction unit (delta unit), an integration unit (sigma unit, which performs an integration/sigma operation), a quantization unit and a delay unit, the device being characterized by further comprising:

- A phase modulator, PM, in the feed-forward branch of the DS converter and a phase demodulator in the feedback brach of the DS converter;
  or
- A frequency modulator, FM, in the feed-forward branch of the DS converter and a frequency demodulator in the feedback brach of the DS converter.

This system may be, for example, a transmitter for transmission of audio or video signals which includes the previously described device.

The system may further comprise a pulse shaping or a digital/analog converter, where the output of the device is connected to the input of the pulse shaping or the digital/analog converter.

The system may further comprise and in-phase/quadrature modulator and where the output of the pulse shaping or the digital/analog converter is the input of the in-phase/quadrature modulator. The carrier frecuency used by the in-phase/quadrature modulator is usually higher than half of the sampling frequency used to sample the analog input signal.

In an embodiment, the output of the pulse shaping or the digital/analog converter (or the output of the in-phase/quadrature modulator if any) is transmitted through a communications channel. The system may further comprise a receiver (to receive the signal transmitted through the communications channel) comprising a sample and hold unit, a phase demodulator or a frequency demodulator, a digital/analog converter and a low pass filter.

In a third aspect, it is proposed a method for analog-to-digital conversion of an analog input signal into a digital output signal, the method being performed by a device comprising a Delta-Sigma, DS, converter, the DS converter comprising a substraction unit, an integration unit, a quantization unit and a delay unit, the method being characterized by:

- Performing a phase modulation (e.g. of the output of the integration unit) in the (main) feed forward branch on the DS converter and performing a correspondent phase demodulation (e.g of the ouput of the quantization unit) in the (main) feedback brach of the DS converter or
- Performing a frequency modulation (e.g. of the output of the integration unit) in the (main) feed forward branch on the DS converter and performing a correspondent frequency demodulation (e.g of the ouput of the quantization unit) in the (main) feedback brach of the DS converter.

According to another aspect of the invention, a computer program product is provided, comprising computer-executable instructions for performing any of the method previously disclosed, when the program is run on a computer and a non-transitory digital data storage medium is also provided encoding a machine-executable program of instructions to perform any of the methods disclosed.

Consequently, according to the invention, a device, method, system, a computer program and a data storage medium according to the independent claims are provided. Favorable embodiments are defined in the dependent claims.

These and other aspects of the invention will be apparent from and elucidated with reference to the embodiments described hereinafter.

**BRIEF DESCRIPTION OF THE DRAWINGS**

To complete the description and in order to provide for a better understanding of the invention, a set of drawings is provided. Said drawings form an integral part of the description and illustrate a preferred embodiment of the invention, which should not be interpreted as restricting the scope of the invention, but just as an example of how the invention can be embodied. The drawings comprise the following figures:

Figure 1 shows a block diagram of a system which uses the NDM converter according to an embodiment of the invention.

Figure 2 shows a block diagram of a system which uses the NDM converter, with a phase (NDM-PM) or frequency (NDM-FM) modulator, according to an embodiment of the invention.

Figure 3 shows (top part) the power spectrum density of the resulting signal of a NDM converter using phase modulation, according to an embodiment of the invention, in a particular scenario. In the bottom part, figure 3 shows, the corresponding power spectrum in the same scenario for a prior art DS converter.

Figure 4 shows the power spectrum density of the resulting signal of a NDM converter using frequency modulation according to an embodiment of the invention, in the same scenario used in figure 3.

Figures 5A, 5B and 5C show the power spectrum density of the conversion noise for a NDM-PM converter (5A), NDM-FM converter (5B) and a prior art DS converter (5C), corresponding to the scenario and parameter settings used in figures 3 and 4.

**DETAILED DESCRIPTION OF THE INVENTION**

The present invention may be embodied in other specific devices, systems and/or methods. The described embodiments are to be considered in all respects as only illustrative and not restrictive. In particular, the scope of the invention is indicated by the appended claims rather than by the description and figures herein. All changes that come within the meaning and range of equivalency of the claims are to be embraced within their scope.

As an example, here below a practical implementation of the invention is described for a generic low pass signal $x(n)$ (produced as a sample/hold version of an analog signal $x(t)$ as it will be explained later). The sample period may be normalized, for the sake of clarity of the presentation, at one.

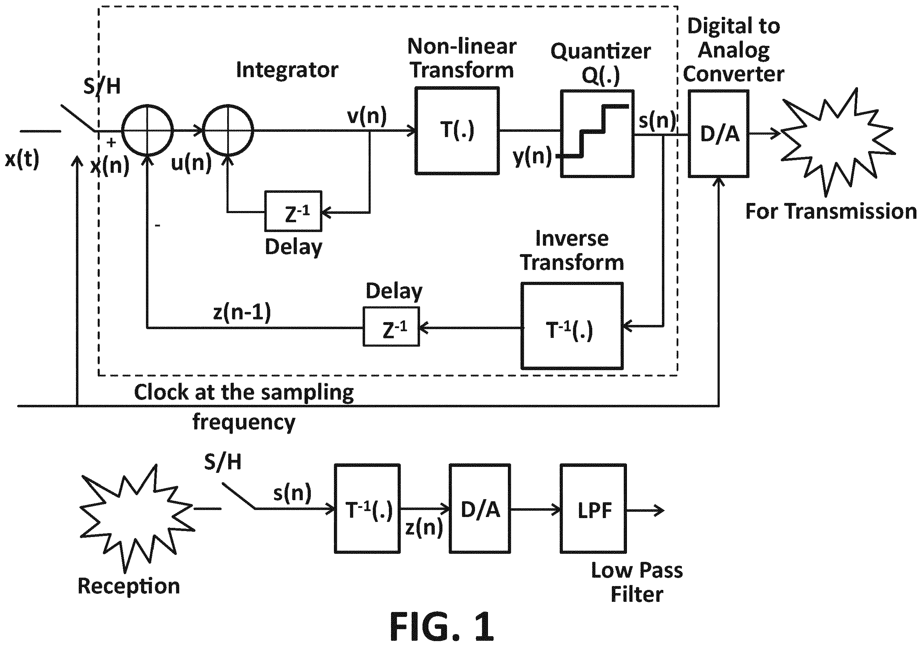

Figure 1 shows a general block diagram of a system which uses the NDM converter according to an embodiment of the invention. The NDM converter mainly comprises the elements included in the dotted lines frame. The input signal $x(t)$ maybe any signal, for example, an electronic signal, an audio or video signal of any other type of signal. In this example, the signal input in the delta-sigma converter, $x(n)$, is assumed to be a sampled/hold version of the analog signal; the dynamic range of the input signal is assumed normalized in the range (-1,1) mV (this is only an example, for clarity, simplicity and explanation purposes). That is, the input analog signal $x(t)$ is applied to a sampled/hold unit (S/H) at a sampling frequency; this sampling frequency may be far above the Nyquist rate in order to produce an oversampled version of the analog signal. As it can be seen from figure 1, the delta (also called substraction) operation is performed subtracting from the input signal $x(n)$ the previous value of the signal $z(n)$ in the lower branch (also called feedback branch or feedback loop). The resulting difference signal, $u(n)$, goes through the sigma operation, which may be performed by a first order integrator (also called integration unit), producing a signal $v(n)$. This integration function in his simplest version may consist on adding the input of the integrator with a delayed version of the output of the integrator (of course, any other more complex integrator may also be used). Signal $v(n)$ is transformed by transform $T(.)$ into $y(n)$ (as it will be later explain, this transform $T$ may be a non-linear transform and, more particularly, it may be a phase modulation or a frequency modulation). Then $y(n)$ is quantized, obtaining the output signal of the converter, $s(n)$ (the quantized version of $y(n)$, representing the quantizer function by $Q(.)$). The quantizer may be for example a mid-riser or a mid-tread quantizer. The output signal $s(n)$ after inverse transform ($T^{-1}(.)$) and delay ($Z^{-1}$) is feedback in the lower branch (feedback branch or feedaback loop) for the delta operation.

There is not need for a digital to analog converter in the feedback branch as the quantized signal is a discrete signal which can be substracted (after inverse transform) from the input signal $x(n)$ (in the delta operation) directly.

Note that with respect to the traditional Delta Sigma converter the invention introduces a transformation in the upper branch as well as the inverse transform in the lower branch. In addition, note that the recovered waveform may be a low pass filtered version of $z(n)$ (this low pass filter is not depicted in the figure). Usually, before using the output $s(n)$ of the Delta Sigma Converter (for example for recording or for being transmitted in a communication channel) said signal goes to a D/A converter or pulse shaping. For recovering a replica of the original signal $x(t)$, (e.g. in reception, when receiving the signal transmitted through the communication channel), the reception signal may be passed through a sample and hold unit, an inverse transformation (of the transformation made in the NDM converter), followed by a D/A converter, followed by an analog low pass filter. This is shown in the bottom part of figure 1.

In figure 1 the modified Delta-Sigma converted (NDM converter) proposed, comprises the main signal processing part (dotted rectangle). The rest of the processing, i.e. sample and hold, D/A converter, low pass filter..., are elements which do not purely belong to the converter, so they will be not further considered (as they are out of the object of the present invention). In addition, in order to compute the signal to noise ratio of the NDM converter, note that a digital low pass filter version of z(n) may provide the recovered signal, i.e. a replica of the input x(n).

As it has been stated, for simplicity and explanation purposes, it has been supposed that the signal input in the delta-sigma converter, is a sampled/hold version (x(n)) of an analog signal. In the case, that an analog input x(t) is applied directly to the NDM converter (withouth sampling and hold at the beginning), the sample and hold can be set at the quantizer (becoming a sort of "analog version" of the NDM shown in figure 1).

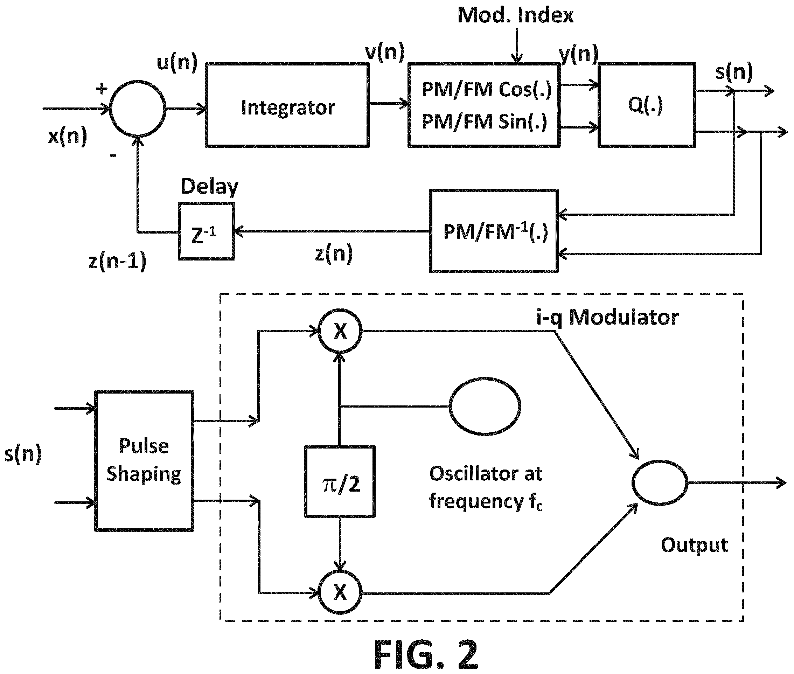

Figure 2 shows a preferred embodiment of the present invention, where the transform T used in the converter, is a phase (NDM-PM) or frequency (NDM-FM) modulation. That is, figure 2 shows a particular case of the system shown in figure 1 where a PM or FM modulator and demodulator is used in the proposed NDM converter. The PM or FM modulator will be situated in the main feed-forward branch (also called direct branch, feedforward branch or upper branch) of the DS converter, that is, in series with the integrator and the quantizer (quantization unit). The correspondent (PM or FM) demodulator is used in the main feedback branch (also called feedback loop), that is in series with the delay unit ($Z^{-1}$) which will feed the delta/substraction operator. Note that the band-pass nature of these modulations requires to modulate both an in phase component as cosine and a quadrature component as sine function respectively (that's why in figure 2, there are shown two outputs of the PM or FM modulation, as the phase and quadrature component of a complex signal y(n)). This processing will be denoted hereafter as Cos(.) and Sin(.). The resulting signals are quantized producing a complex (two component) signal s(n) that after demodulation (and delay) is used for the feedback as in the previous figure. As stated for figure 1, before using the output s(n) of the Delta Sigma Converter (for example for recording or for being transmitted in a communication channel wired or wireless), said signal may go to a D/A converter or pulse shaping (in case of figure 2 a pulse shaping is shown). After this pulse shaping, the i-q components are usually processed at a carrier frequency $f_c$ by an i-q modulator. The pulse shaping sets the bandwidth of transmission and the i-q modulator sets the central frequency or carrier of the transmission. Note that the waweform at the output of the i-q modulator will be like a digital phase or frequency modulation, i.e. similar to a PSK or FSK digital modulation.

This produces, for each mixer or multiplier, within the i-q modulator, the in-phase and quadrature components of an analog signal at the carrier frequency ($\cos(2\pi f_c t)$ and $\sin(2\pi f_c t)$).

The particular arrangement shown in figures 1 and 2 are only examples; the order and location of the elements (delta operation, integrator, non linear transform, quantizer...) shown in said figures is not mandatory. That is, said elements can be arranged in other ways (different locations and order) in the system converter proposed by the present invention (for example the inverse transform can be situated after the delay...). The main feature is that the non-linear transform (PM or FM modulator) is in the feed-forward branch (in series with the integrator and the quantizer) and the correspondent inverse transfor (PM or FM demodulator) is in the feedback branch of the converter. In order to be more clear (and to avoid any misunderstanding, as in the DS converter there may be more than one feed-forward and feedback branches), it can be said that the PM or FM modulator will be situated in the feed-forward branch of the basic loop of the DS converter (also called main feed-forward branch), that is, in series with the integrator and the quantizer. The correspondent (PM or FM) demodulator will be located in the feedback branch of the basic loop (also called main feedback branch), that is in series with the delay unit ($Z^{-1}$) which will feed the delta/substraction operator. As in a DS converter there can be other secondary loops (for example in the integrator), the expression "basic loop" is used to refer to the main loop of the DS converter, that is the loop formed in its feedforward branch by the delta (substraction) operation, the sigma (integrator) operation and the quantizer (and the non-linear trasnsformation in case of NDM converters) and in its feedback branch formed by the delay unit ($Z^{-1}$) which feeds the delta operation (and the non-linear inverse trasnsformation in case of NDM converters).

Of course the demodulator in the feedback branch of the basic loop should be the corresponding demodulator to the modulator (FM or PM) used in the feed-forward branch of the basic loop, that is, it must perform the inverse function of the modulation performed by the modulator (so it usually uses the corresponding same parameters and coefficients than the modulator).

Now the particular operation of the NDM converter, using the arrangement shown in figure 2, will be explained with more detail:

The delta operation produces signal u(n) as the difference between the input signal x(n) and the previous sample of z(n) (in figures 1 and 2, the expression $Z^{-1}$ is used to denote an operation in which a signal is delayed one sample)

$$u(n) = x(n) - z(n-1)$$

The sigma (integration) operation is implemented by an integrator that produces v(n) as:

$$v(n) = v(n-1) + u(n) \; or \; v(n) - v(n-1) = u(n) = x(n) - z(n-1)$$

For PM modulation (NDM-PM), the modulator forms the in-phase and quadrature components of v(n) as follows, where $\varphi_d$ is the phase modulation index.

$$\cos(\varphi_d v(n))$$

$$\sin(\varphi_d v(n))$$

For FM modulation (NDM-FM), v(n) is integrated and the resulting signal vfm(n) ($vfm(n) = vfm(n-1) + v(n)$) modulates the in phase and quadrature components as it is shown below, where $f_d$ is the frequency modulation index.

$$\cos(2\pi f_d vfm(n))$$

$$\sin(2\pi f_d vfm(n))$$

The pair of in-phase and quadrature components can be represented as the real and imaginary parts of the following complex signal y(n) for PM (Phase Modulation) and FM (Frequency Modulation) respectively.

$$y(n) = PM(v(n)) = \exp(j\varphi_d v(n)) \; or \; y(n) = FM(v(n)) = \exp(j2\pi f_d vfm(n))$$

For simplicity purposes, without loss of generality the case in which PM modulation is used (NDM-PM) will be explained from now on (the same explanation will be valid, mutatis mutandis, to the NDM-FM case). As before was shown that v(n)- v(n -1) = x(n)- z(n -1), the following expression in the NDM-PM is valid:

$$PM(v(n) - v(n-1)) = PM(x(n) - z(n-1))$$

As the exponential function converts sum in a product and subtraction in a quotient, (both for PM and FM), then it follows that:

$$PM(v(n))/PM(v(n-1)) = PM(x(n))/PM(z(n-1))$$

Taking into account the expression of y(n)=PM(v(n)), the following result is obtained:

$$y(n)/y(n-1) = PM(x(n))/PM(z(n-1))$$

After the quantizer, the signal s(n), considering the quantizer as an additive noise source with complex value w(n), may be formulated as:

$$s(n) = y(n) + w(n) \; or \; y(n) = s(n) - w(n)$$

Note that the previous equations imply that the quantizer is linearized. In other words, it is assumed that the quantization noise is independent of the input value. This is not formally correct for low numbers of quantization levels. Nevertheless, linearizing the quantizer provides light into the resulting performance of the converter (even for low number of levels when the independence claimed is not totally correct), so said assumption is going to be used as it leads to valid results about the converter performance.

Substituting this in the above formula of y(n), it is obtained a relationship between the output of the NDM-PM s(n) and the input x(n).

$$(s(n)-w(n))/(s(n-1)-w(n-1))=PM(x(n))/PM(z(n-1))$$

In addition, since z(n) is the PM inverse of s(n), that is, z(n)=PM$^{-1}$(s(n)), so PM(z(n))= PM(PM$^{-1}$(s(n)))=s(n). Using this in the above formula, the following final expression is obtained:

$$s(n)-w(n) =(s(n-1)-w(n-1))PM(x(n))/s(n-1)$$

or

$$s(n) = PM(x(n))+w(n)-((PM(x(n))/s(n-1))w(n-1))$$

It can be shown that this expression remains the same for the FM modulator just changing function PM(.) by FM(.). That is, when using FM modulation:

$$s(n) = FM(x(n))+w(n)-((FM(x(n))/s(n-1))w(n-1))$$

Thus s(n) is a discrete version of a phase modulation or frequency modulation of the original input signal plus a noise factor (this noise factor will be w(n)-((PM(x(n))/s(n-1))w(n-1)) for PM modulation or w(n)-((FM(x(n))/s(n-1))w(n-1)) for FM modulation). This noise suffers the desired noise shaping, i.e. loaded to high frequency due to the minus sign affecting the one sample delayed version of it. The difference in the shaping is that this factor multiplying w(n-1) is one for DS and in the present invention the delayed noise sample is multiplied by the quotient between the desired signal of s(n), i.e. the PM or FM version of the input x(n), divided by the previous output s(n-1). Clearly under low noise regime and high oversampling factor (SNR$_Q$ greater than 30 dB and r>5, where r=log$_2$(B$_T$/2B), being r the oversampling gain) shaping becomes almost identical to the obtained on the traditional $\Delta\Sigma$ modulator.

It is worthwhile to mention that the phase modulation step (the implementation of the phase modulation), i.e. passing from the output of the integrator to the output s(n), can be done directly from the use of a look-up table which resumes the PM modulation and the quantizer. This reduces greatly the complexity of the modulator whenever the number of levels is small, i.e. two or three levels quantizers. This applies also for the demodulation embedded in the lower branch. In fact the look at table passes directly from the input of the modulator to the reconstructed phase values at the lower branch.

Under this model the performance of the NDM versus DS will increase due to the modulation. For PM the gain will be close to 20log$_{10}$(($\varphi_d$) dB, which will be close to 10 dB for $\varphi_d$ equal to its maximum value of $\pi$ (i.e. no ambiguouty in the phase load), and for FM will be close to 10 log$_{10}$(3(f$_d$/B)$^2$), where B is the bandwidth of the original low pass input signal.

Note that, for a given number of bits for each quantizer the number of levels used is twice of the traditional DS converter since there are two quantizers, one for the phase component and another one for the quadrature component, acting in parallel. For a number of bits in the quantizers greater than 2 (i.e. more than 3 levels per quantizer) this amounts for an extra gain of 6 dB due to the fact that the number of levels used in NDM is twice the number of levels used in DS. For the case of 1 bit, the quantization noises and original signal are correlated and no significant gain should be expected due to the use of two quantizers in parallel in this respect.

Using these values, an increase of 9.94 dB for NDM-PM ($\varphi_d = \pi$) and 34 for NDM-FM (modulation index f$_d$=0.2, B$_{3dB}$=0.0039 of the input signa) improvement versus DS can be expected plus the extra bit due to the use of two quantizers in parallel. Using a sinusoid at frequency 0.002 (all frequencies are normalized by the sampling frequency) as input signal, the resulting SNRs are shown below.

The SNR$_Q$ for DS may be calculated using the following prior-art formula (see for example Dave Van Ess, "Signal from Noise: Calculating Delta-Sigma SNRs". EN-Genius Network. www.en-genius.net), which provides the SNR$_Q$

of the DS for different order L and oversampling factor n.

$$SNR_Q^{DS}(dB.) = 3.01n(2L+1) - 9.36L - 2.76$$

For order one (L=1) and oversampling factor of approx. 7 (i.e. $\log_2(B_T/(2B) = \log_2(1/(2*0.0039))$, the resulting SNR is 50.95 dB.

The following table shows the gains in dB of the converters. It is denoted as "Expected" the estimates mentioned before of 9.94 for NDM-PM and 34 for NDM-FM as the modulation gains, plus the fix gains that the converter has. Also the loss of 9.36 and 2.76 for the DS modulator (see formula above) are not present for the NDM converter.

|  | DS 1bit | NDM-PM 1bit | NDM-FM(mid-tread) |
|---|---|---|---|
| Measured | 51 dB | 77.12 dB | 107.52 dB |
| Measured - DS (51 dB) | reference | 26.12 dB | 56.52 dB |
| Expected | reference | 9.94+12.12+6=28.06dB | 34+12.12+12=58.12dB |

Note that regardless the severe approximations the NDM expected gains (last file of the table), due to angle modulation, and the measured gains are very close.

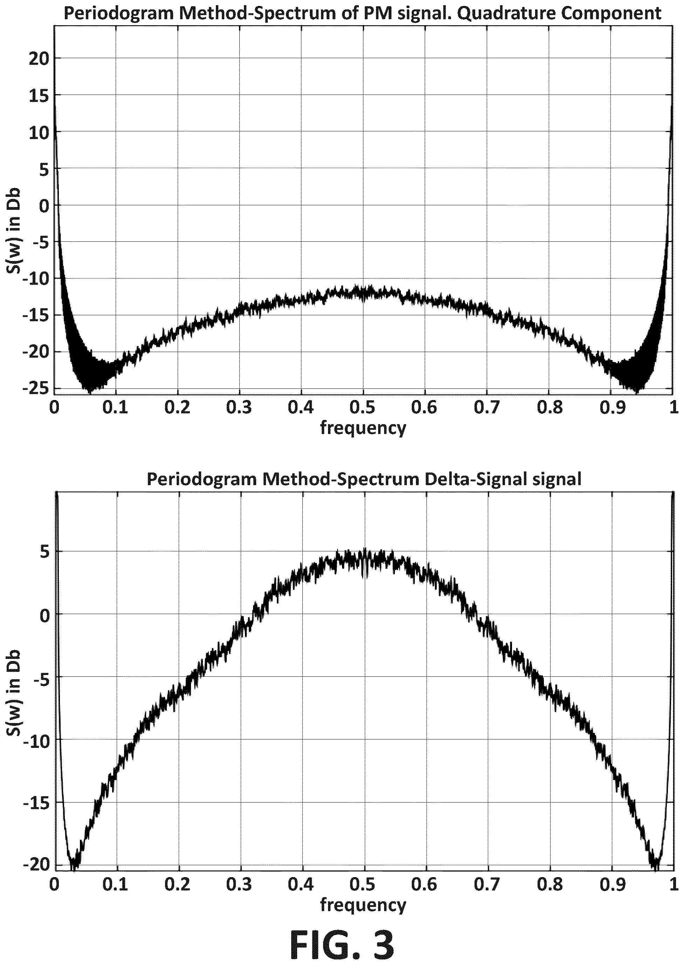

The top part of figure 3 shows the power spectrum density of the resulting signal s(n) of the NDM converter (NDM-PM converter) in a particular case. For the result shown in figure 3, the power spectrum density is computed from the average of periodograms of records of 256 samples of the output signal s(n), for the quadrature component only (the power spectrum density for the phase component will be the same). The record length was $10^5$ samples. The input signal is noise of uniform distribution filtered at 0.0039 (3dB bandwidth). The dynamic range of the signal is +/- 1 mV. The parameters used in the converter have been: A PM modulator with modulation index $\varphi_d$ equal to $\pi$ (maximum phase deviation), carrier amplitude 1 volt, sampling rate normalized to one (T=1), 1 bit mid-riser quantizer of 2 levels for both in-phase and quadrature components. The decision levels of the quantizer were +/-0.5 mV. The input signal was white noise with a FIR of 512 coefficients with a bandwidth B of equal to 0.0039.The plot set the averaged periodogram in dB versus the frequency between zero and the sampling frequency equal to 1 (symmetric with respect half the sampling frequency) The resolution of the frequency plot is $9.76 \cdot 10^{-5}$.

In the bottom part of figure 3, the corresponding power spectrum for a prior art DS converter with 1-bit mid-riser 2 levels quantizer is shown.

Note that the noise shaping is well present in both converters. This effect is masked partially for NDM-PM due to the high spectral dynamic range of the PM signal. Note that the power of output signal is the same in DS and NDM converters, in consequence the area of both spectral densities are the same. Of course, the selected carrier frequency does not affect the final $SNR_Q$ quality of the converter since, at the receiver site, the PM detector extracts the unwrapped carrier phase.

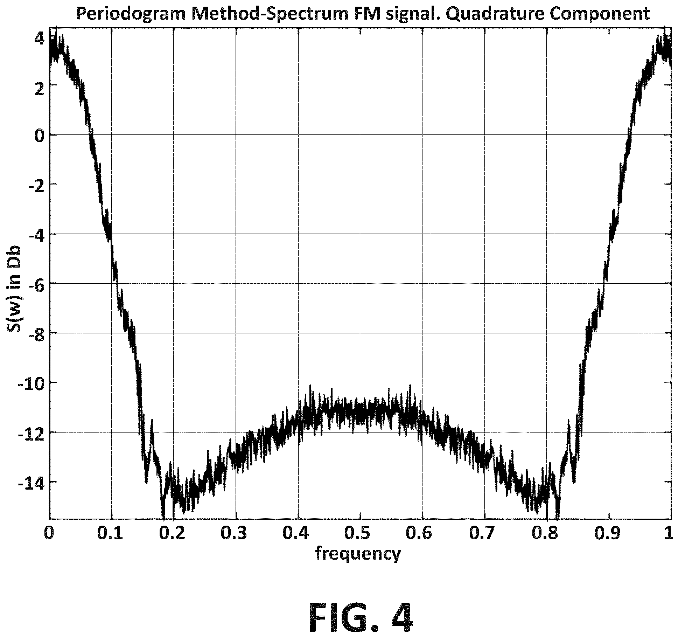

Figure 4 shows the power spectrum density of the resulting signal of a NDM converter (NDM-FM converter), i.e. the case of using an FM modulator. The parameters set is the same that in Figure 3. The only difference is the modulation index $f_d$, which in this figure is 0.2. The quantizers used were mid-tread. Note that in addition to the wideband nature of FM the shaping is still preserved in the quatization noise.

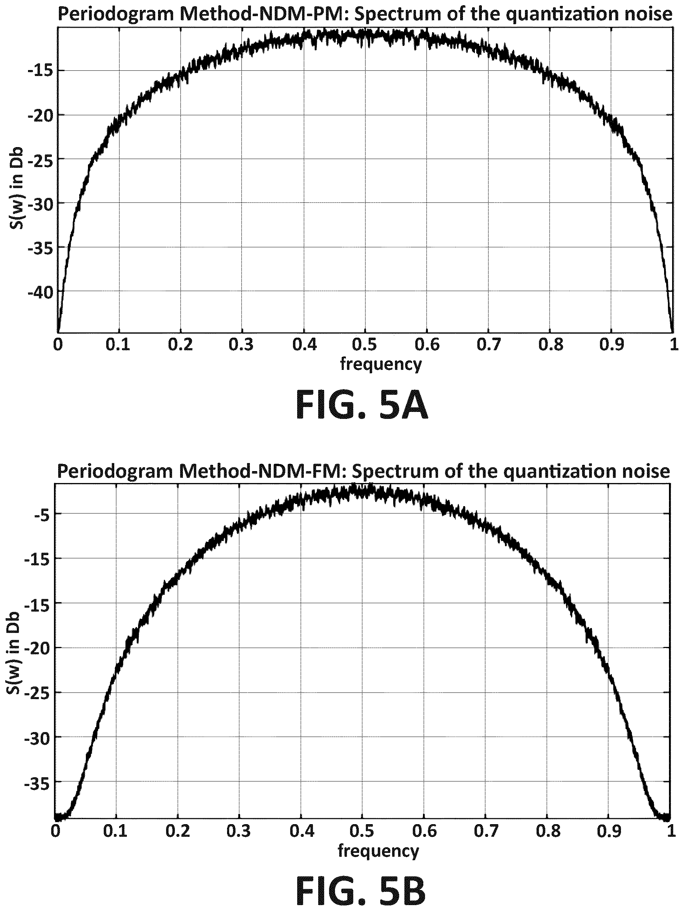

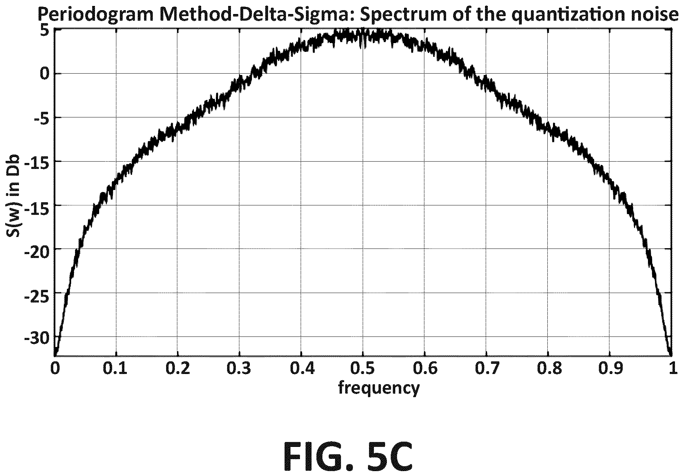

Figures 5 shows the power spectrum density of the quantization noise for a NDM-PM converter (5A), NDM-FM converter (5B) and a prior art DS converter (5C) corresponding to the scenario and parameter settings used in previous figures. The quantization noise is measured here as the difference between the input signal x(n) and the feedback signal z(n) taking into account all the existing delays within the loop, so even it is called "quantization" noise, it is more a conversion "noise" as it is the noise introduced by the conversion. Note that the noise floor at low frequencies, where the input signal is located, is lower in NDM-PM than in DS and, for the case of NDM-FM is also low and flat exhibiting a behavior similar to the order two DS (not depicted here). This is due to the inherent double integration at the upper branch of the NDM-FM caused by the FM modulator.

Now some general considerations about the proposed converter, as well as, some examples of the improvement obtained with the proposed converter in different scenarios are going to be explained:

The I-Q Modulator: As stated in figure 2, before using the output s(n) of the Delta Sigma Converter, said signal may go to a D/A converter or pulse shaping and then through an I-Q modulator. As PM and FM are modulations intrinsically of band pass nature, this modulator is usually required. Since the inphase and quadrature are done in the low pass NDM loop (top of figure 2), this represents that two streams are representing the original signal after the loop. The i-q modulator, previous pulse shaping, put together at the output these two streams in a single band-pass analog signal. Note that this modulation is usually done at a frequency fc greater than half of the sampling frequency. The PM-FM modulations at central frequencies ($f_c$) above half of the sampling frequency (in wireless transmission usually far above) allows to resume in a single signal the two signals (in-phase and quadrature) coming up from the NDM loop.

FM and the threshold effect: In frequency modulation for low SNR, there is a threshold effect well described in prior art literature. Basically, the effect is motivated by the use of a high modulation index $f_d$ (in consequence large detection bandwidths). This threshold effect appears as peaks or glitches when detecting the instantaneous frequency that degrade the recovered SNR. This causes for example that using a mid-tread (2 levels) quantizer for 1-bit NDM-FM converter presents lower SNR than expected due to the threshold effect. For NDM-PM there is not threshold effect for the oversampling ratio used in the figures independently of the number of levels of the quantizer. To overpass the threshold effect, as it is the case of NDM-FM, 1-bit mid-riser for the signal scenario should be selected, otherwise it would be necessary a phase locked loop (PLL) which reduces the processing bandwidth and restores the SNR of the converter. In other words, when working with high modulation indexes, to avoid the necessity of using a PLL device (which will imply an increase of complexity), the levels of the quantizer should be increased (for example, increasing one level (mid-riser) the quantizer (mid-tread).

NDM Line Signal: The line signal or output of the NDM-PM converter for a two levels quantizer, is in fact a 4 PSK (Phase Shift Keying) modulation with phases equal to $\pm\pi/4, \pm3\pi/4$. And the NDM-FM line signal is like a DPSK (differential PSK) over the previous four-point constellation of phases. Note that for the mid-tread (3 levels) quantizer the constellations of phases pass to be $\pm\pi/8, \pm3\pi/8, \pm5\pi/8, 7\pi/8$. In other words a 8PSK (constellation of 8 phases) signal. In consequence, the NDM-PM innovation can be encompassed as a device converting an analog signal directly to a digital band-pass PSK modulation.

High order NDM converters: High order NDM can be implemented by the addition to the NDM of traditional extra delta-sigma loops. The gains obtained are shown below for the following scenario:

| Scenario | - Sampling period T | normalized to 1 ($f_{sampling}$=1) |
|---|---|---|
| | - Original signal: | sinusoid frequency 0.002 3dB-bandwidth set to 0.0039 Dynamic range: (-1,1) mV. |
| | - Quantizers | mid-riser for DS, mid-tread for NDM-FM and mid-riser for |
| | - NDM-PM | Modulation index $\pi$ radians |
| | - SNR | Signal to noise ratio at the output |

| Number of bits | SNR DS (order 2) | NDM-PM (order 2) |
|---|---|---|
| 1 | 84.23 dB | 115.16 dB (Mid-tread converter) |
| 2 | 92.58 dB | 117.42 dB |
| 3 | 96.65 dB | 124.16 dB |
| 4 | 98.03 dB | 129.93 dB |

Performance order 1 converters above 1 bit:
Scenario The same used in the previous item.

| Number of bits | NDM-PM | NDM-FM |
|---|---|---|
| 2 | 79.11 dB | 109.67 dB |
| 3 | 90.14 dB | 115.72 dB |
| 4 | 86.53 dB | 127.02 dB |
| 5 | 103.20 dB | 133.14 dB |

It is worth to mention that NDM-FM performs similar to NDM-PM ($\varphi_d = \pi$) when the FM modulator uses an index equal to 0.025. Note that NDM-FM entails the use of two integrators, i.e. one of the loop and another in the modulator, as well as NDM-PM of order two. Amazingly NDM-PM of order two provides better $SNR_Q$ than NDM-FM of order one. It is important to mention that NDM-PM entails a narrow band modulation meanwhile NDM-FM is wideband without taking full advantage of the noise shaping. In addition, it should be mentioned that the receiver for FM is simpler than for PM, furthermore the receiver for FM can be fully analog and un-coherent.

Some of the advantages of the converter proposed by the present invention are, for example:

- High dynamics (50-100 dB) obtained by low bit converters are currently fully installed on audio signal sensing and distribution. In addition to the high dynamics, the major innovation of the invention relies on the ability to convert directly a time continuous signal, or a sample/hold version of it, in a constant envelope digital modulated waveform. The resulting waveform is a constant envelope carrier modulated either in phase or frequency (PSK or FSK). This implies that the converter implements a source coding or representation in terms of a finite set of phases in the i/q (in-phase and quadrature) components of a pre-selected carrier frequency, i.e. channel coding. This enables to interchange between communications nodes high dynamic range signals and, at the same time, providing protection against radio-channel noise of the coded signal.

- The impact, especially in Internet of Things (IoT) networks, is very high since the sensing part is almost independent of the corresponding RF part with the corresponding limitations in performance. In addition, the invention represents a way out to the, let us say, traditional, low dynamic and low bandwidth that ambient sensors use to handle.

- The proposed converter represents an innovation impacting the wireless and wired sensor production from distributed acoustic processing down to ambient sensing.

- The NDM-FM converter can produce narrowband Frequency Modulation enabling the converter to work with a wide range of transmission bandwidths for the desired signal.

- The angle modulations embedded in NDM converters protects the NDM converted signal from channel noise, whenever the phase/frequency detector stays above the threshold effect.

- The increase in the power of the line signal, PM/FM modulated, produces greater protection to channel noise than linear modulations.

- The i-q components in the proposed NDM converter are quantized independently allowing either the arrangement in a single carrier or the time multiplexing of the two streams, yet preserving its superiority with respect to traditional DS converter (double oversampling factor).

- The NDM converter can be easily extended to high order modulators NDM-PM and NDM/FM.

- NDM-PM modulators of order n+1 are better than NDM-FM of order n, with slightly lower complexity than NDM-FM. At the same time the spectral bandwidth of NDM-PM desired signal shows better spectrum confinement for the desired that NDM-FM.

- The NDM converter implements a joint source channel coding that converts a baseband analog signal in a high rate digital phase modulation (QPSK or 8PSK for 1 bit per quantizer).

The different elements (units) cited as part of the proposed NDM converter may be signal processing units (or devices), computing devices or any other type of electronic devices with performs the corresponding function. This is valid, for example, for the element which performs the substraction (delta) operation (called for example substraction unit), the element which performs the integration (sigma) operation or function (called integration unit or integrator), the element which performs the quantization operation or function (called quantization unit or quantizer), the element which performs the sample and hold operation or function, the element which performs the delay operation or function (called delay unit), the modulator, the demodulator, the filters or any other element.

The presented embodiments may be embodied in other specific devices, systems and/or methods. The described embodiments are to be considered in all respects as only illustrative and not restrictive. In particular, the scope of the invention is indicated by the appended claims rather than by the description and figures herein. All changes that come within the meaning and range of equivalency of the claims are to be embraced within their scope

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

The functions of the various elements shown in the figures, including any functional blocks titled as "processors", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. A signal processing device for non-linear analog-to-digital converting of an analog input signal into a digital output signal, comprising a Delta-Sigma, DS, converter, the DS converter comprising a subtraction unit, an integration unit, a quantization unit and a delay unit, the device being **characterized by** further comprising:

   - A phase modulator, PM, in the feed-forward branch of the DS converter for performing phase modulation of either the signal integrated by the integration unit or the signal quantized by the quantization unit, and a phase demodulator in series with the delay unit in the feedback branch of the DS converter, where the phase demodulator is the corresponding demodulator to the phase modulator, performing the inverse function of the modulation performed by the phase modulator in the feed-forward branch or

   - A frequency modulator, FM, in the feed-forward branch of the DS converter for performing frequency modulation of either the signal integrated by the integration unit or the signal quantized by the quantization unit, and a frequency demodulator in series with the delay unit in the feedback branch of the DS converter, where the frequency demodulator is the corresponding demodulator to the frequency modulator, performing the inverse function of the modulation performed by the frequency modulator in the feed-forward branch.

2. The device according to claim 1 where the phase modulator or the frequency modulator is connected in series with the quantization unit and where the output of the phase modulator or the frequency modulator is connected to the input of the quantization unit and where the output of the quantization unit is the digital output signal of the device.

3. The device according to any of the preceding claims where the phase modulator or the frequency modulator is connected in series with the integration unit and where the input of the phase modulator or the frequency modulator is connected to the output of the integration unit.

4. The device according to any of the preceding claims where the phase modulator or the frequency modulator is connected in series with the subtraction unit, the integration unit and the quantization unit of the DS converter and where the input of the phase modulator or the frequency modulator is connected to the output of the integration unit, the output of the phase modulator or the frequency modulator is connected to the input of the quantization unit and where the output of the subtraction unit is connected to the input of the integration unit.

5. The device according to any of the preceding claims where the input of the phase demodulator or the frequency demodulator is connected to the output of the quantization unit.

6. The device according to any of the preceding claims where the output of the phase demodulator or the frequency demodulator is connected to the input of the delay unit and the output of the delay unit is the input of a subtraction unit.

7. The device according to any of the preceding claims 1-5 where the device further comprises a low pass filter, where the output of the phase demodulator or the frequency demodulator is connected to the input of the delay unit, where the input of the the low pass filter is connected to the output of the delay unit and where the output of the low pass filter is an input of the subtraction unit

8. The device according to any of the preceding claims, the device further comprising a sample and hold unit which processes the analog input signal at a selected sampling frequency and where the resulting sampled signal is an input of the subtraction unit of the DS converter.

9. The device according to any of the preceding claims where the analog input signal is an audio signal, a video signal and audio-video signal or any type of electronic signal.

10. The device according to any of the preceding claims where the output of the phase modulator or the frequency modulator includes an in-phase component and a quadrature component.

11. A system which comprises a device according to claims 1-10, the system further comprising a pulse shaping or a digital/analog converter and where the output of the device is connected to the input of the pulse shaping or the digital/analog converter.

12. A system according to claim 11, the system further comprising and in-phase/quadrature modulator and where the output of the pulse shaping or the digital/analog converter is the input of the in-phase/quadrature modulator.

13. A system according to claim 11, where the output of the pulse shaping or the digital/analog converter is transmitted through a communications channel, the system further comprising a receiver comprising a sample and hold unit, a phase modulator or a frequency demodulator, a digital/analog converter and a low pass filter.

14. A method for non-linear analog-to-digital conversion of an analog input signal into a digital output signal, the method being performed by a device comprising a Delta-Sigma, DS, converter, the DS converter comprising a subtraction unit, an integration unit, a quantization unit and a delay unit, the method being **characterized by**:

- Performing a phase modulation in the feed forward branch on the DS converter of either the signal integrated by the integration unit or the signal quantized by the quantization unit, and performing a phase demodulation, by a phase demodulator in series with the delay unit, in the feedback brach of the DS converter, where the phase demodulation is the corresponding demodulation to the phase modulation, performing the inverse function of the phase modulation of the feed-forward branch or
- Performing a frequency modulation in the feed forward branch on the DS converter of either the signal integrated by the integration unit or the signal quantized by the quantization unit, and performing a frecuency demodulation, by a frequency demodulator in series with the delaty unit, in the feedback branch of the DS converter, where the frequency demodulation is the corresponding demodulation to the frequency modulation, performing the inverse function of the frequency modulation of the feed-forward branch.

15. A non-transitory digital data storage medium encoding a machine-executable program of instructions to perform a method according to claim 14.

**Patentansprüche**

1. Signalverarbeitungsvorrichtung zum nichtlinearen Analog-Digital-Umwandeln eines analogen Eingangssignals in ein digitales Ausgangssignal, umfassend einen Delta-Sigma-DS-Wandler, wobei der DS-Wandler eine Subtraktionseinheit, eine Integrationseinheit, eine Quantisierungseinheit und eine Verzögerungseinheit umfasst, wobei die Vorrichtung **dadurch gekennzeichnet ist, dass** sie ferner umfasst:

- einen Phasenmodulator, PM, im Vorwärtskopplungszweig des DS-Wandlers zur Durchführung einer Phasenmodulation entweder des von der Integrationseinheit integrierten Signals oder des von der Quantisierungseinheit quantisierten Signals, und einen Phasendemodulator, in Reihe geschaltet mit der Verzögerungseinheit im Rückkopplungszweig des DS-Wandlers, wobei der Phasendemodulator der dem Phasenmodulator entsprechende Demodulator ist, der die Umkehrfunktion der vom Phasenmodulator im Vorwärtskopplungszweig durchgeführten Modulation ausführt; oder
- einen Frequenzmodulator, FM, im Vorwärtskopplungszweig des DS-Wandlers zur Durchführung einer Frequenzmodulation entweder des von der Integrationseinheit integrierten Signals oder des von der Quantisierungseinheit quantisierten Signals, und einen Frequenzmodulator, in Reihe geschaltet mit der Verzögerungseinheit im Rückkopplungsszweig des DS-Wandlers, wobei der Frequenzdemodulator der dem Frequenzmodulator entsprechende Demodulator ist, der die Umkehrfunktion der vom Frequenzmodulator im Vorwärtskopplungszweig durchgeführten Modulation ausführt.

2. Vorrichtung nach Anspruch 1, wobei der Phasenmodulator oder der Frequenzmodulator mit der Quantisierungseinheit in Reihe geschaltet ist und wobei der Ausgang des Phasenmodulators oder des Frequenzmodulators mit dem Eingang der Quantisierungseinheit verbunden ist und bei wobei der Ausgang der Quantisierungseinheit das digitale Ausgangssignal des Geräts ist.

3. Vorrichtung nach irgendeinem der vorhergehenden Ansprüche, wobei der Phasenmodulator oder der Frequenzmodulator mit der Integrationseinheit in Reihe geschaltet ist und wobei der Eingang des Phasenmodulators oder des Frequenzmodulators mit dem Ausgang der Integrationseinheit verbunden ist.

4. Vorrichtung nach irgendeinem der vorhergehenden Ansprüche, wobei der Phasenmodulator oder der Frequenzmodulator mit der Subtraktionseinheit, der Integrationseinheit und der Quantisierungseinheit des DS-Wandlers in Reihe geschaltet ist, und wobei der Eingang des Phasenmodulators oder des Frequenzmodulators mit dem Ausgang der Integrationseinheit verbunden ist, wobei der Ausgang des Phasenmodulators oder des Frequenzmodulators mit dem Eingang der Quantisierungseinheit verbunden ist, und wobei der Ausgang der Subtraktionseinheit mit dem Eingang der Integrationseinheit verbunden ist.

5. Vorrichtung nach irgendeinem der vorhergehenden Ansprüche, bei der der Eingang des Phasendemodulators oder des Frequenzdemodulators mit dem Ausgang der Quantisierungseinheit verbunden ist.

6. Vorrichtung nach irgendeinem der vorhergehenden Ansprüche, wobei der Ausgang des Phasendemodulators oder des Frequenzdemodulators mit dem Eingang der Verzögerungseinheit verbunden ist, und wobei der Ausgang der Verzögerungseinheit der Eingang einer Subtraktionseinheit ist.

7. Vorrichtung nach einem der vorhergehenden Ansprüche 1 bis 5, wobei die Vorrichtung ferner ein Tiefpassfilter umfasst, wobei der Ausgang des Phasendemodulators oder des Frequenzdemodulators mit dem Eingang der Verzögerungseinheit verbunden ist, wobei der Eingang des Tiefpassfilters mit dem Ausgang der Verzögerungseinheit verbunden ist, wobei der Ausgang des Tiefpassfilters ein Eingang der Subtraktionseinheit ist.

8. Vorrichtung nach irgendeinem der vorhergehenden Ansprüche, wobei die Vorrichtung ferner eine Abtast- und Halteeinheit umfasst, die das analoge Eingangssignal bei einer ausgewählten Abtastfrequenz verarbeitet und bei der das resultierende abgetastete Signal ein Eingang der Subtraktionseinheit des DS-Wandlers ist.

9. Vorrichtung nach irgendeinem der vorhergehenden Ansprüche, wobei das analoge Eingangssignal ein Audiosignal, ein Videosignal und ein Audio-VideoSignal oder irgendeine Art von elektronischem Signal ist.

10. Vorrichtung nach irgendeinem der vorhergehenden Ansprüche, wobei der Ausgang des Phasenmodulators oder des Frequenzmodulators eine gleichphasige Komponente und eine Quadraturkomponente beinhaltet.

11. System, das eine Vorrichtung nach den Ansprüchen 1 bis 10 umfasst, wobei das System ferner einen Impulsformungs- oder einen Digital/Analog-Wandler umfasst und wobei der Ausgang der Vorrichtung mit dem Eingang des Impulsformungs- oder des Digital/Analog-Wandlers verbunden ist.

12. System nach Anspruch 11, wobei das System ferner einen In-Phase/Quadratur-Modulator umfasst und wobei der Ausgang des Impulsformungs- oder des Digital/Analog-Wandlers der Eingang des In-Phase/Quadratur-Modulators ist.

13. System nach Anspruch 11, wobei der Ausgang des Impulsformungs- oder des Digital/Analog-Wandlers über einen Kommunikationskanal übertragen wird, wobei das System ferner einen Empfänger umfasst, der eine Abtast- und Halteeinheit, einen Phasenmodulator oder einen Frequenzdemodulator, einen Digital/Analog-Wandler und ein Tiefpassfilter umfasst.

14. Verfahren zur nichtlinearen Analog-Digital-Umwandlung eines analogen Eingangssignals in ein digitales Ausgangssignal, wobei das Verfahren von einer Vorrichtung durchgeführt wird, die einen Delta-Sigma (DS)-Wandler umfasst, wobei der DS-Wandler eine Subtraktionseinheit, eine Integrationseinheit, eine Quantisierungseinheit und eine Verzögerungseinheit umfasst, wobei das Verfahren **gekennzeichnet ist durch**:

- Durchführen einer Phasenmodulation im Vorwärtskopplungszweig am DS-Wandler entweder des von der Integrationseinheit integrierten Signals oder des von der Quantisierungseinheit quantisierten Signals, und Durchführen einer Phasendemodulation **durch** einen Phasendemodulator, in Reihe geschaltet mit der Verzögerungseinheit im Rückkopplungszweig des DS-Wandlers, wobei die Phasendemodulation die der Phasenmodulation entsprechende Demodulation ist, bei der die Umkehrfunktion der Phasenmodulation des Vorwärtskopplungszweigs ausgeführt wird; oder
- Durchführen einer Frequenzmodulation im Vorwärtskopplungszweig am DS-Wandler entweder des von der Integrationseinheit integrierten Signals oder des von der Quantisierungseinheit quantisierten Signals, und Durchführen einer Frequenzdemodulation **durch** einen Frequenzdemodulator, in Reihe geschaltet mit der Verzögerungseinheit im Rückkopplungszweig des DS-Wandlers, wobei die Frequenzdemodulation die der Frequenzmodulation entsprechende Demodulation ist, bei der die Umkehrfunktion der Frequenzmodulation des Vorwärtskopplungszweigs ausgeführt wird.

15. Ein nicht-flüchtiges digitales Datenspeichermedium, das ein maschinenausführbares Befehlsprogramm codiert, um ein Verfahren nach Anspruch 14 durchzuführen.

**Revendications**

1. Dispositif de traitement de signal pour la conversion analogique-numérique non linéaire d'un signal d'entrée analogique en un signal de sortie numérique, comprenant un convertisseur Delta-Sigma, DS, le convertisseur DS comprenant une unité de soustraction, une unité d'intégration, une unité de quantification et une unité de retard, le dispositif étant **caractérisé en ce qu'**il comprend en outre :

   - un modulateur de phase, PM, dans la branche sans rétroaction du convertisseur DS pour effectuer une modulation de phase soit du signal intégré par l'unité d'intégration soit du signal quantifié par l'unité de quantification, et un démodulateur de phase en série avec l'unité de retard dans la branche de rétroaction du convertisseur DS, où le démodulateur de phase est le démodulateur correspondant au modulateur de phase, effectuant la fonction inverse de la modulation effectuée par le modulateur de phase dans la branche sans rétroaction ; ou
   - un modulateur de fréquence, FM, dans la branche sans rétroaction du convertisseur DS pour effectuer une modulation de fréquence soit du signal intégré par l'unité d'intégration soit du signal quantifié par l'unité de quantification, et un démodulateur de fréquence en série avec l'unité de retard dans la branche de rétroaction du convertisseur DS, où le démodulateur de fréquence est le démodulateur correspondant au modulateur de fréquence, effectuant la fonction inverse de la modulation effectuée par le modulateur de fréquence dans la branche sans rétroaction.

2. Dispositif selon la revendication 1, où le modulateur de phase ou le modulateur de fréquence est connecté en série avec l'unité de quantification et où la sortie du modulateur de phase ou le modulateur de fréquence est connecté à l'entrée de l'unité de quantification et où la sortie de l'unité de quantification est le signal de sortie numérique du dispositif.

3. Dispositif selon l'une quelconque des revendications précédentes, où le modulateur de phase ou le modulateur de fréquence est connecté en série avec l'unité d'intégration et où l'entrée du modulateur de phase ou du modulateur de fréquence est connectée à la sortie de l'unité d'intégration.

4. Dispositif selon l'une quelconque des revendications précédentes, où le modulateur de phase ou le modulateur de fréquence est connecté en série avec l'unité de soustraction, l'unité d'intégration et l'unité de quantification du convertisseur DS et où l'entrée du modulateur de phase ou du modulateur de fréquence est connectée à la sortie de l'unité d'intégration, la sortie du modulateur de phase ou du modulateur de fréquence est connectée à l'entrée de l'unité de quantification et où la sortie de l'unité de soustraction est connectée à l'entrée de l'unité d'intégration.

5. Dispositif selon l'une quelconque des revendications précédentes, où l'entrée du démodulateur de phase ou du démodulateur de fréquence est connectée à la sortie de l'unité de quantification.

6. Dispositif selon l'une quelconque des revendications précédentes, où la sortie du démodulateur de phase ou du démodulateur de fréquence est connectée à l'entrée de l'unité de retard et la sortie de l'unité de retard est l'entrée d'une unité de soustraction.

7. Dispositif selon l'une quelconque des revendications 1 à 5 précédentes, où le dispositif comprend en outre un filtre passe-bas, où la sortie du démodulateur de phase ou du démodulateur de fréquence est connectée à l'entrée de l'unité à retard, où l'entrée du filtre passe-bas est connectée à la sortie de l'unité de retard et où la sortie du filtre passe-bas est une entrée de l'unité de soustraction.

8. Dispositif selon l'une quelconque des revendications précédentes, le dispositif comprenant en outre une unité d'échantillonnage et de maintien qui traite le signal d'entrée analogique à une fréquence d'échantillonnage sélectionnée et où le signal échantillonné résultant est une entrée de l'unité de soustraction du convertisseur DS.

9. Dispositif selon l'une quelconque des revendications précédentes, où le signal d'entrée analogique est un signal audio, un signal vidéo et un signal audio-vidéo ou tout type de signal électronique.

10. Dispositif selon l'une quelconque des revendications précédentes, où la sortie du modulateur de phase ou du modulateur de fréquence comprend une composante en phase et une composante en quadrature.

11. Système qui comprend un dispositif selon les revendications 1 à 10, le système comprenant en outre un convertisseur de mise en forme d'impulsions ou numérique/analogique et où la sortie du dispositif est connectée à l'entrée du convertisseur de mise en forme d'impulsions ou numérique/analogique.

12. Système selon la revendication 11, le système comprenant en outre un modulateur en phase/en quadrature et où la sortie du convertisseur de mise en forme d'impulsions ou numérique/analogique est l'entrée du modulateur en phase/en quadrature.

13. Système selon la revendication 11, où la sortie du convertisseur de mise en forme d'impulsions ou numérique/analogique est transmise à travers un canal de communication, le système comprenant en outre un récepteur comprenant une unité d'échantillonnage et de maintien, un modulateur de phase ou un démodulateur de fréquence, un convertisseur numérique/analogique et un filtre passe-bas.

14. Procédé de conversion analogique-numérique non linéaire d'un signal d'entrée analogique en un signal de sortie numérique, le procédé étant effectué par un dispositif comprenant un convertisseur Delta-Sigma, DS, le convertisseur DS comprenant une unité de soustraction, une unité d'intégration, une unité de quantification et une unité de retard, le procédé étant **caractérisé par** :

- une réalisation d'une modulation de phase dans la branche sans rétroaction sur le convertisseur DS soit du signal intégré par l'unité d'intégration soit du signal quantifié par l'unité de quantification, et une réalisation d'une démodulation de phase, par un démodulateur de phase en série avec l'unité de retard, dans la branche de rétroaction du convertisseur DS, où la démodulation de phase est la démodulation correspondante à la modulation de phase, effectuant la fonction inverse de la modulation de phase de la branche sans rétroaction ; ou
- une réalisation d'une modulation de fréquence dans la branche sans rétroaction sur le convertisseur DS soit du signal intégré par l'unité d'intégration soit du signal quantifié par l'unité de quantification, et une réalisation d'une démodulation de fréquence, par un démodulateur de fréquence en série avec l'unité de retard, dans la branche de rétroaction du convertisseur DS, où la démodulation de fréquence est la démodulation correspondante à la modulation de fréquence, effectuant la fonction inverse de la modulation de fréquence de la branche sans rétroaction.

15. Support de stockage de données numériques non transitoire codant un programme d'instructions exécutable par machine pour effectuer un procédé selon la revendication 14.

FIG. 1

**FIG. 2**

**Periodogram Method-Spectrum of PM signal. Quadrature Component**

**Periodogram Method-Spectrum Delta-Signal signal**

# FIG. 3

Periodogram Method-Spectrum FM signal. Quadrature Component

FIG. 4

**Periodogram Method-NDM-PM: Spectrum of the quantization noise**

FIG. 5A

**Periodogram Method-NDM-FM: Spectrum of the quantization noise**

FIG. 5B

FIG. 5C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P.M.AZIZ ; H.V. SORENSEN ; J.VAN DER SPIEGEL.** An overview of Sigma-Delta Converters: How 1-bit ADC achieves more than 16-bit resolution. *IEEE Signal Processing Magazine,* September 1996, vol. 13 (1), 61-84

- **M HOVIN ; A. OLSEN ; T. SVERRE LANDE ; C. TOUMAZOU.** Delta-Sigma Modulators using Frequency-Modulated Intermediate Values. *IEEE Journal of Solid State Circuits,* January 1997, vol. 32 (1), 13-22